(19) Europäisches Patentamt
European Patent Office
Office européen des brevets

(11) Veröffentlichungsnummer : **0 599 779 A1**

(12) # EUROPÄISCHE PATENTANMELDUNG

(21) Anmeldenummer : **93810737.2**

(51) Int. Cl.$^5$ : **G03F 7/004**

(22) Anmeldetag : **20.10.93**

(30) Priorität : **29.10.92 CH 3369/92**

(43) Veröffentlichungstag der Anmeldung :
**01.06.94 Patentblatt 94/22**

(84) Benannte Vertragsstaaten :
**BE CH DE FR GB IT LI NL**

(71) Anmelder : **OCG Microelectronic Materials AG**
**Klybeckstrasse 141**
**CH-4002 Basel (CH)**

(72) Erfinder : **Münzel, Norbert, Dr.**
**Im Clausenfeld 3**
**D-79423 Heitersheim (DE)**
Erfinder : **Schulz, Reinhard, Dr.**
**Am Pfarrgarten 5a**
**D-79219 Staufen-Wettelbrunn (DE)**
Erfinder : **Holzwarth, Heinz**
**St. Blasierweg 2**
**D-79189 Bad Krozingen (DE)**

(74) Vertreter : **Roueche, Armand et al**
**c/o CIBA-GEIGY AG,**
**Patentabteilung,**
**Postfach**
**CH-4002 Basel (CH)**

(54) **Hochauflösender negativ arbeitender Photoresist mit grossem Prozessspielraum.**

(57) Es wird ein chemisch verstärkter, wässerig-alkalisch entwickelbarer Negativ-Photoresist beschrieben, der einen strahlungsempfindlichen Säuregenerator und eine Verbindung, die unter dem Einfluss von Säure die Löslichkeit des Resists in wässerig-alkalischen Lösungen herabsetzt, sowie eine Polyhydroxylverbindung der Formel I enthält

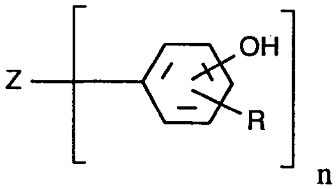

(I),

worin n eine ganze Zahl zwischen 2 und 6 und R Wasserstoff, Halogen, $C_1$-$C_4$-Alkoxy oder $C_1$-$C_4$-Alkyl bedeuten sowie Z einen n-wertigen, unsubstituierten oder einen oder mehrere Substituenten aus der Gruppe Hydroxyl-, Halogen- und
$C_1$-$C_4$-Alkoxy-Substituenten aufweisenden Rest darstellt, ausgewählt aus der Gruppe bestehend aus :
a) aliphatischen Resten mit 1 bis 12 Kohlenstoffatomen,
b) cycloaliphatischen Resten mit 5 bis 20 Kohlenstoffatomen,
c) aromatischen Resten mit 6 bis 20 Kohlenstoffatomen und
d) Resten mit 7 bis 30 Kohlenstoffatomen, die aus mindestens zwei verschiedenen Strukturelementen zusammengesetzt sind, ausgewählt aus aliphatischen, cycloaliphatischen oder aromatischen Gruppen.
Die beschriebenen Resists ermöglichen es, die Anforderungen an die Genauigkeit der Fokussierung bei der bildmässigen Belichtung herabzusetzen.

EP 0 599 779 A1

Die Erfindung betrifft einen chemisch verstärkten, wässerig-alkalisch entwickelbaren Negativ-Photoresist und ein Verfahren zur Herstellung von negativen Abbildungen unter Verwendung dieser Resists.

Chemisch verstärkte, wässerig-alkalisch entwickelbare Photoresists sind bekannt. Negativ-Photoresists dieses Typs sind z. B. in der EP-A-0 404 499 beschrieben und zeigen im allgemeinen eine gegenüber herkömmlichen Resists gesteigerte Auflösung. Sie enthalten zumindest einen strahlungsempfindlichen Säuregenerator, d. h. chemische Gruppen, die unter dem Einfluss von aktinischer Strahlung Säure bilden, sowie Gruppen, die, katalysiert von der hierbei gebildeten Säure, eine chemische Reaktion eingehen, die die Löslichkeit des Resists in der Entwicklerlösung herabsetzt. Die chemische Reaktion, die zur Herabsetzung der Löslichkeit des Resists fuhrt, kann z. B. eine säurekatalysierte Vernetzungsreaktion zwischen einer oder mehreren Komponenten der Resistzusammensetzung sein.

Neben diesen Hauptkomponenten enthalten die Photoresists im allgemeinen noch andere Komponenten, die bestimmte Eigenschaften verbessern sollen. In der EP-A-0 445 058 ist beispielsweise ein negativ arbeitender Photoresist beschrieben, der Triphenylsulfoniumtriflat als strahlungsempfindlichen Säuregenerator und ein Epoxynovolakharz als Bindemittel enthält. Das Bindemittel bildet gleichzeitig die Verbindung, die, katalysiert von der bei Bestrahlung des Resists gebildeten Säure, härtet, d. h. eine chemische Reaktion eingeht, die die Löslichkeit des Resists in einem geeigneten Entwickler herabsetzt. Zusätzlich enthält dieser Resist noch eine Polyhydroxylverbindung, Hydrochinon, in einer Menge von 2,5 Gewichtsprozent, um die Strahlungsempfindlichkeit zu steigern.

Die Erzeugung einer in bestimmter Weise strukturierten Resistbeschichtung auf einem Substrat erfolgt nach einer weit verbreiteten Methode so, dass man eine zunächst auf dem Substrat aufgebrachte zusammenhängende Beschichtung aus der Resistzusammensetzung durch eine Maske bestrahlt, die nur in gewünschten Bereichen die Strahlung bis zur Beschichtung durchdringen lässt, so dass an diesen Stellen die Löslichkeit der Resistbeschichtung sinkt, und danach mit einem Entwickler die löslichen Teile der Beschichtung herauslöst.

Bestimmte Eigenschaften der bekannten Negativresists können jedoch immer noch nicht voll befriedigen. So erfordert die immer stärkere Miniaturisierung, insbesondere in der Mikroelektronik, die Auflösung immer kleinerer Strukturen. Beispielsweise ist für die Herstellung integrierter 16 Mbit Speicherbausteine noch eine Auflösung von Strukturen zwischen 0,5 und 0,6 µm ausreichend, für die Herstellung von 64 Mbit Speichern aber muss das Auflösungsvermögen des Resists schon unter 0,4 µm liegen. Ausserdem stellen die bekannten Photoresists noch zu hohe Anforderungen an die Genauigkeit der Fokussierung bei der bildmässigen Belichtung, insbesondere wenn Strukturen im Submikrometer- oder Subhalbmikrometerbereich aufgelöst werden sollen.

Es soll daher ein neuer negativ arbeitender Photoresist zur Verfügung gestellt werden, der so zusammengesetzt ist, dass er eine verbesserte Auflösung bei gleichzeitig vergrössertem Fokusspielraum ermöglicht.

Bei dem erfindungsgemässen Resist handelt es sich um einen chemisch verstärkten, wässerig-alkalisch entwickelbaren Negativ-Photoresist, der einen strahlungsempfindlichen Säuregenerator, und eine monomere oder polymere Verbindung, die unter dem Einfluss von Säure die Löslichkeit des Resists in wässerig-alkalischen Lösungen herabsetzt, sowie eine Polyhydroxylverbindung enthält und der dadurch gekennzeichnet ist, dass die Polyhydroxylverbindung die Formel I aufweist

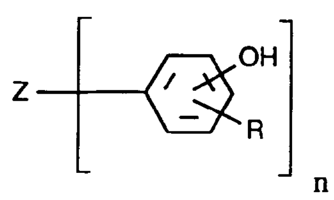

(I),

worin

- n eine ganze Zahl zwischen 2 und 6 und
- R Wasserstoff, Halogen, $C_1$-$C_4$-Alkoxy oder $C_1$-$C_4$-Alkyl bedeuten sowie
- Z einen n-wertigen, unsubstituierten oder einen oder mehrere Substituenten aus der Gruppe Hydroxyl-, Halogen- und $C_1$-$C_4$-Alkoxy-Substituenten aufweisenden Rest darstellt, ausgewählt aus der Gruppe bestehend aus:

  a) aliphatischen Resten mit 1 bis 12 Kohlenstoffatomen,
  b) cycloaliphatischen Resten mit 5 bis 20 Kohlenstoffatomen,
  c) aromatischen Resten mit 6 bis 20 Kohlenstoffatomen und
  d) Resten mit 7 bis 30 Kohlenstoffatomen, die aus mindestens zwei verschiedenen Strukturelementen zusammengesetzt sind, ausgewählt aus aliphatischen, cycloaliphatischen oder aromatischen Gruppen.

Bedeutet Z in Formel I einen aliphatischen Rest, so kann es sich um einen geradkettigen oder verzweigten aliphatischen Rest entsprechender Kohlenstoffzahl handeln, wie z.B. um eine n-wertige von Ethan, Propan, Isopropan, Butan, tert.-Butan, Pentan, Hexan oder Octan abgeleitete Gruppe. Bevorzugt handelt es sich bei den aliphatischen Resten Z um geradkettige Reste mit 2 bis 4 Kohlenstoffatomen.

Als cycloaliphatische Reste Z kommen z. B. n-wertige Reste in Frage, die sich von Cyclopentan, Cyclohexan, Cycloheptan oder Bi-cyclohexyl ableiten.

Bedeutet Z in Formel I einen aromatischen Rest, so kann es sich z. B. um einen Rest handeln, den man sich durch die Wegnahme von n Wasserstoffatomen von Benzol, Naphthalin, Biphenyl oder Terphenyl abgeleitet vorstellen kann.

Beispiele von Resten mit 7 bis 30 Kohlenstoffatomen, die aus mindestens zwei verschiedenen Strukturelementen zusammengesetzt sind, ausgewählt aus aliphatischen, cycloaliphatischen oder aromatischen Gruppen stellen n-wertige Gruppen, die sich von Verbindungen wie Ethylheptan, Toluol, Xylol, 2,2-Bisphenylpropan, Biscyclohexylmethan, 2-Cyclohexyl-2-phenyl-propan oder Fluoren ableiten.

Polyhydroxylverbindungen der genannten Art sind bekannt und in vielfacher Form kommerziell erhältlich. Sie sind z. B. in an sich bekannter Weise durch die säurekatalysierte Umsetzung von Polyolen, Ketonen und Aldehyden bzw. Polyketonen und Polyaldehyden mit Phenolen geeigneter Struktur erhältlich. Beispiele für die Darstellung dieser Verbindungen findet man beispielsweise in Houben-Weyl, "Methoden der organischen Chemie", 4. Auflage, Band VI/1c "Phenole/Teil2", Georg Thieme Verlag Stuttgart 1976, S. 1022 - 1032 und in dem belgischen Patent Nr. 576,136 oder der US-A-3,689, 572.

Im allgemeinen ist der Einsatz von Polyhydroxylverbindungen der Formel I bevorzugt, worin R Wasserstoff bedeutet, ausserdem der solcher Verbindungenvon Formel I, worin n entweder 3 oder 4 bedeutet, ebenso wie der Einsatz von Verbindungen mit der Struktur

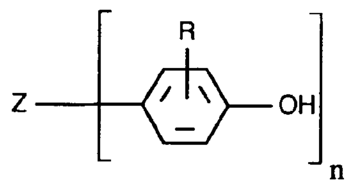
,

wobei n, Z und R die schon genannten Bedeutungen haben, R aber bevorzugt Wasserstoff darstellt. Eine Kombination der vorgenannten Strukturmerkmale ist besonders bevorzugt, insbesondere wenn zusätzlich der Rest Z einer der nachfolgend aufgeführten bevorzugten Formen entspricht.

Bevorzugte Reste Z stellen aliphatische Reste mit 2 bis 4 Kohlenstoffatomen sowie Reste, die aus aromatischen und aliphatischen Strukturelementen aufgebaut sind, und bevorzugt 7 bis 20 Kohlenstoffatome enthalten. Weiterhin ist es bevorzugt, wenn die Reste Z unsubstituiert sind, d. h. keine Hydroxyl-, Halogen- oder $C_1$-$C_4$-Alkoxy-Substituenten aufweisen.

Beispiele für erfindungsgemäss ganz besonders geeignete Verbindungen der Formel I sind 1,1,2,2-Tetrakis(4-hydroxyphenyl)ethan; 1,2,2,3-Tetrakis(4-hydroxyphenyl)propan 1,3,3,5-Tetrakis(4-hydroxyphenyl)pentan und insbesondere die Verbindung der Formel II

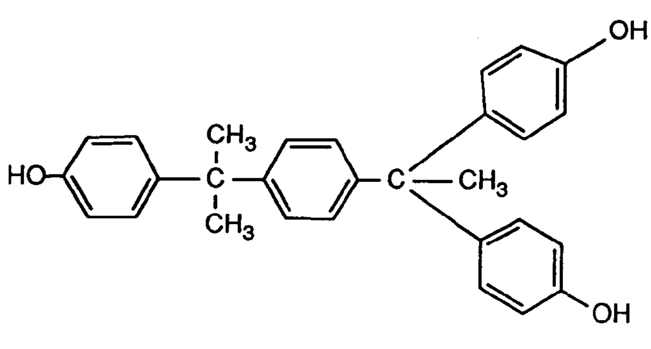
(II).

Die erfindungsgemässen Negativresists enthalten die Polyhydroxylverbindungen der Formel I im allgemeinen in einer Menge von mindestens 5 Gewichtsprozent, bezogen auf den Gesamtfeststoffgehalt des Resists. Die Obergrenze liegt zweckmässig bei etwa 30 Gewichtsprozent. Sehr gut geeignet ist ein Gehalt von 10 bis 20 Gewichtsprozent.

Die Auswahl des strahlungsempfindlichen Säuregenerators ist bei der vorliegenden Erfindung nicht kritisch, so dass an im allgemeinen alle hierfür bekannten Verbindungen eingesetzt werden können. Der Fachmann wird die Auswahl z. B. aufgrund der Strahlung treffen, mit der er den Resist härten möchte.

Zu den für die Erfindung geeigneten strahlungsempfindlichen Säuregeneratoren zählen beispielsweise Halogenverbindungen, die bei Bestrahlung Halogenwasserstoffsäure bilden. Verbindungen dieses Typs sind beispielsweise in der US-A-3,515,552, US-A-3,536,489 oder US-A-3,779,778, sowie in der DE-A-2,718,259, DE-A-2,243,621 oder der DE-A-2,610,842 beschrieben.

Als strahlungsempfindliche Komponenten der erfindungsgemässen Negativresistzusammensetzung eignen sich auch Oniumverbindungen, wie Iodonium- oder Sulfoniumsalze. Solche Verbindungen sind in "UV-Curing, Science and Technology", insbesondere S. 13 ff. (Editor: S. P. Pappas, Technology Marketing Corp., 642 Westover Road, Stanford, Connecticut, USA, 1985) beschrieben und bilden den Gegenstand vieler Patentschriften, z. B. der US-Patentschriften 4,058,400, 4,058,401 und 4,069,055.

Auch Diaryliodosyl-Salze sind einsetzbar. Solche Verbindungen sind beispielsweise in der EP-A-106,797 beschrieben.

Ferner können Sulfoxoniumsalze als strahlungsempfindliche Verbindungen verwendet werden. Sie sind beispielsweise in der EP-B-0 035 969 oder in den EP-A-0 044 274 bzw. EP-A-0 054 509 beschrieben. Aliphatische Sulfoxoniumsalze, die im tiefen UV-Bereich absorbieren, sind beispielsweise in der EP-A-0 164 314 beschrieben.

Eine weitere Gruppe geeigneter strahlungsempfindlicher Säuregeneratoren stellen Metallocensalze dar, die unter anderem in der EP-A-0 094 915 beschrieben sind.

Weiterhin lassen sich auch Verbindungen einsetzen, die unter aktinischer Strahlung Sulfonsäuren freisetzen. Solche Verbindungen sind z. B. in der GB-A 2,120,263, den EP-A 0 084 515, EP-A-0 037 152 oder EP-A-0 058 638 bzw. in der US-A-4,371,605 beschrieben.

Zu diesen Verbindungen gehören auch Oximsulfonatverbindungen, wie sie beispielsweise in der EP-A-0 139 609 und der EP-A-0 241 423 beschrieben sind. Spezielle Photoinitiatoren dieses Typs sind die in der Europäischen Patentanmeldung Nr. 93810358.7 beschriebenen Oximsulfonate der Formel III

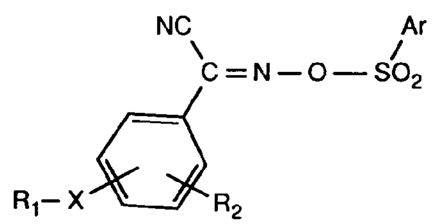

(III),

worin Ar eine unsubstituierte Arylgruppe oder eine Arylgruppe darstellt, die einen oder mehrere Chlor-, Brom-, Hydroxyl-, $C_1$-$C_4$-Alkyl-, $C_1$-$C_4$-Perfluoralkyl- oder $C_1$-$C_4$-Alkyloxy-Substituenten aufweist; X ein Sauerstoff- oder Schwefelatom; $R_1$ Wasserstoff, $C_1$-$C_4$-Alkyl oder eine unsubstituierte oder eine Chlor-, Brom-, $C_1$-$C_4$-Alkyl-, $C_1$-$C_4$-Alkyloxysubstituenten aufweisende Phenylgruppe und $R_2$ Wasserstoff, $C_1$-$C_4$-Alkyl-Substituenten bedeuten. Bevorzugt bedeutet Ar hierbei eine Arylgruppe der Formel

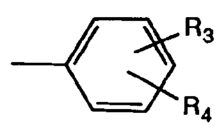

,

X ein Sauerstoffatom, $R_1$ einen $C_1$-$C_4$-Alkyl- oder Phenylrest und $R_2$, $R_3$ und $R_4$ unabhängig voneinander Wasserstoff, Chlor oder Methyl. Diese Photoinitiatoren, z.B. α-(4-Toluol-sulfonyloxyimino)-4-methoxybenzylcyanid, eignen sich sehr gut bei Verwendung von Strahlung aus dem Bereich der Quecksilber I-Linie (Wellenlänge 365 Nanometer) zur Belichtung.

Bevorzugt werden die Photosäurebildner, die unter Bestrahlung Sulfonsäuren oder Halogensäuren freisetzen, insbesondere Iminosulfonate. Der Gehalt der erfindungsgemässen Resists an strahlungsempfindlichen Säuregeneratoren sollte etwa zwischen 0,1 und 20 Gewichtsprozent betragen, bezogen auf den Gesamtfeststoff des Resists, wobei aufgrund der vielen in Frage kommenden Typen von Säuregeneratoren grössere Schwankungen möglich sind.

Als Verbindungen, die unter dem Einfluss der bei Bestrahlung der Säuregenerators gebildeten Säure die

Löslichkeit des Resists in wässerig-alkalischen Lösungen herabsetzen, eignen sich z. B. die bekannten säurehärtbaren Harze, wie beispielsweise Acryl-, Polyester-, Alkyd-, Melamin-, Harnstoff-, Epoxid- und Phenolharze oder Gemische davon. Säurehärtbare Harze wie diese sind allgemein geläufig und z. B. in Ullmann's Encyclopädie der technischen Chemie, Aufl. 4, Bd. 15(1978), S. 613 - 628 beschrieben.

Besonders bevorzugt als säurehärtbare Harze sind Aminoharze, wie z. B. unveretherte oder veretherte Melamin-, Harnstoff-, Guanidin- oder Biuretharze, insbesondere methylierte Melaminharze oder butylierte Melaminharze, entsprechende Glycolurile und Urone. Unter Harze werden hierbei sowohl die üblichen technischen Gemische, die im allgemeinen auch Oligomere und enthalten, als auch die reinen und hochreinen definierten Verbindungen verstanden. Hexamethoxymethylmelamin (Formel IV) sowie Tetramethoxymethylglycoluril (Formel V) und N,N'-Dimethoxymethyluron (Formel VI) sind die am meisten bevorzugten säurehärtbaren Harze

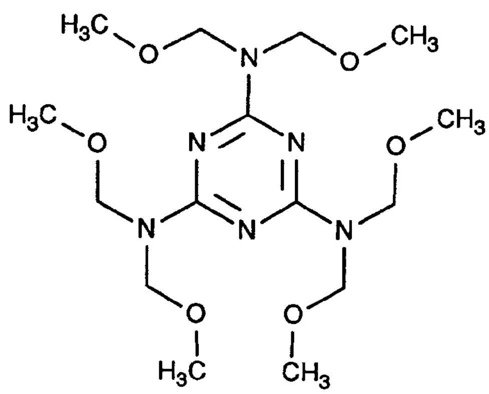
(IV);
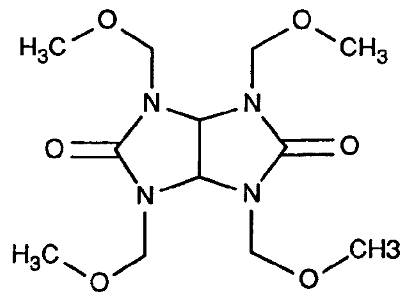
(V);

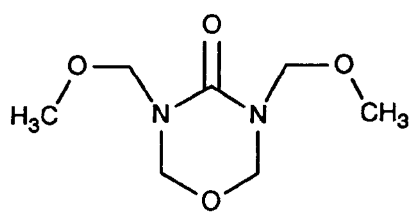
(VI).

Der Anteil dieser Komponente kann in grossen Grenzen variieren. Bei Anwesenheit eines zusätzlichen filmbildenden polymeren Bindemittels beträgt er im allgemeinen 2 bis 30 Gewichtsprozent, bezogen auf den Feststoffgehalt des Resists.

Ein zusätzliches filmbildendes polymeres Bindemittel ist zumindest dann erforderlich, wenn die säurehärtbare Verbindung nicht selbst als Bindemittel für die Resistzusammensetzung fungieren kann. Besonders gut hierfür geeignet sind alkalilösliche Phenolharze, z. B. Novolake, abgeleitet von einem Aldehyd, beispielsweise Acetaldehyd oder Furfuraldehyd, insbesondere jedoch von Formaldehyd, und einem Phenol, z. B. unsubstituiertem Phenol, ein- oder zweifach chlorsubstituiertem Phenol, wie p-Chlorphenol, ein- oder zweifach mit $C_1$-$C_9$-Alkyl substituiertem Phenol, wie o-, m- oder p-Kresol, den verschiedenen Xylenolen, p-tert.-Butylphenol, p-Nonylphenol, p-Phenylphenol, Resorcin, Bis-(4-hydroxyphenyl)-methan oder 2,2-Bis-(4-hydroxyphenyl)-propan. Weiterhin sind geeignet Homo- und Copolymere auf Basis ethylenisch ungesättigter Phenole, z. B. Homopolymere von vinyl- und 1-propenylsubstituierten Phenolen, wie p-Vinylphenol oder p-(1-Propenyl)phenol oder Copolymere dieser Phenole mit einem oder mehreren ethylenisch ungesättigten Materialien, beispielsweise Styrolen. Die Menge des Bindemittels liegt im allgemeinen zwischen 30 und 90 Gewichtsprozent oder bevorzugt zwischen 40 und 80 Gewichtsprozent, bezogen auf den Feststoffgehalt des Resists.

Selbstverständlich können anstatt einzelner Stoffe im allgemeinen auch Gemische von mehreren Vertretern der einzelnen oben beschriebenen Komponenten eingesetzt werden.

Eine spezielle Ausführungsform der erfindungsgemässen Negativresists enthält 40 bis 87, insbesondere 52 bis 77 Gewichtsprozent eines Phenolharzes als Bindemittel, bevorzugt eines Novolakes oder Polyvinylphenols, 5 bis 25, insbesondere 5 bis 20 Gewichtsprozent eines Stoffes ausgewählt aus Hexamethoxymethylmelamin (Formel IV) oder Tetramethoxymethylglycoluril (Formel V) und N,N'-Dimethoxymethyluron (Formel VI), sowohl in hochreiner oder technischer Form, 0,1 bis 10, insbesondere 1 bis 10 Gewichtsprozent einer Verbindung, die bei Bestrahlung Sulfonsäuren oder Halogensäuren bildet, sowie 5 bis 25, insbesondere 10 bis 25 Gewichtsprozent einer Polyhydroxylverbindung aus der Gruppe 1,1 ,2,2-Tetrakis(4-hydroxyphenyl)ethan; 1,2,2,3-Tetrakis(4-hydroxyphenyl)propan 1,3,3,5-Tetrakis(4-hydroxyphenyl)pentan und der Verbindung der oben schon angeführten Formel II. Gut geeignet wäre z. B. ein Resist bestehend aus 60 bis 75 Gewichtsprozent Novolakharz, z. B. eines m-Kresol oder eines m/p-Kresol Novolaks, 7,5 bis 17,5 Gewichtsprozent Hexamethoxymethylmelamin, 12,5 bis 17,5 Gewichtsprozent der Polyhydroxylverbindung mit oben angeführten Formel II und 0,5 bis 5 Gewichtsprozent α-(4-Toluol-sulfonyloxyimino)-4-methoxybenzylcyanid als Photosäuregenerator.

Die erfindungsgemässen Photoresistzusammensetzungen können ausser den genannten Bestandteilen noch einen oder mehrere der für Negativresists üblichen Zusatzstoffe in den für den Fachmann gebräuchlichen Mengen enthalten, z. B. Verlaufsmittel, Netzmittel, Haftmittel, Thixotropiemittel, Farbstoffe, Pigmente, Füllstoffe, Löslichkeitsbeschleuniger, Sensibilisierungsmittel und so fort.

Einen weiteren Gegenstand der vorliegenden Erfindung bildet ein Verfahren zur Erzeugung von Abbildungen, das folgende Schritte enthält:

1.) Erzeugung einer Beschichtung bestehend aus einem der hierin beschriebenen Photoresist auf einem Substrat;

2.) bildmässige Belichtung des beschichteten Substrats mit Hilfe des Projektionsbelichtungsverfahrens; gegebenenfalls Erwärmung und

3.) Entwicklung mit Hilfe eines wässerig-alkalischen Entwicklers.

Zur Applikation müssen die Zusammensetzungen im allgemeinen noch ein Lösungsmittel enthalten. Beispiele für geeignete Lösungsmittel sind Ethyllactat, 3-Methoxymethylpropionat, 3-Ethoxyethyl-propionat, Ethylpyruvat, 2-Heptanon, Diethylglycoldimethylether, Cyclopentanon, Cyclohexanon, γ-Butyrolacton, Ethylmethylketon, 2-Ethoxyethanol, 2-Ethoxyethylacetat und insbesondere 1-Methoxy-2-propylacetat. Als Lösungsmittel kann auch ein Gemisch vorliegen, z. B. aus zwei oder mehreren der vorgenannten Lösungsmittel. Die Wahl des Lösungsmittels und die Konzentration richten sich z. B. nach der Art der Zusammensetzung und nach dem Beschichtungsverfahren.

Die Lösung wird mittels bekannten Beschichtungsverfahren auf ein Substrat gleichförmig aufgebracht, z.B. durch Schleudern, Tauchen, Rakelbeschichtung, Vorhanggiessverfahren, Aufpinseln, Sprühen und Reverse Rollbeschichtung. Es ist auch möglich, die lichtempfindliche Schicht auf einen temporären, flexiblen Träger zu bringen, und dann durch Schichtübertragung (Laminierung) das endgültige Substrat zu beschichten.

Die Auftragsmenge (Schichtdicke) und Art des Substrates (Schichtträger) sind abhängig vom gewünschten Applikationsgebiet. Der Schichtdickenbereich kann prinzipiell Werte von ca. 0,1 µm bis mehr als 100 µm umfassen.

Mögliche Einsatzgebiete der erfindungsgemässen Zusammensetzung sind die Verwendung als Photoresists für die Elektronik, die Herstellung von Druckplatten, wie Offsetdruckplatten oder Siebdruckformen, der Einsatz beim Formteilätzen und insbesondere der Einsatz als Mikroresist bei der Herstellung integrierter Schaltkreise.

Entsprechend unterschiedlich sind die Schichtträger und Verarbeitungsbedingungen.

Beim Einsatz als Mikroresist für integrierte und hochintegrierte Schaltkreise, wie es bevorzugt ist, liegen die Schichtdicken im allgemeinen zwischen 0,1 und 10 µm, bevorzugt zwischen 0,5 und 5 µm, insbesondere zwischen 0,5 und 1,5 µm.

Die erfindungsgemässen Zusammensetzungen eignen sich hervorragend als Beschichtungsmittel für Substrate aller Art, einschliesslich Holz, Textilien, Papier, Keramik, Glas, Kunststoffe, wie Polyester, z. B. Polyethylenterephthalat, Polyolefine oder Celluloseacetat, insbesondere in Form von Filmen, insbesondere aber zur Beschichtung von Metallen, wie Ni, Fe, Zn, Mg Co oder insbesondere Cu und Al, sowie von Si, Siliciumoxiden oder -nitriden oder anderen in der Halbleiterindustrie üblichen Substraten, auf denen durch bildmässiges Belichten eine Abbildung aufgebracht werden soll.

Nach dem Beschichten wird das Lösungsmittel in der Regel durch Erwärmen entfernt, und es resultiert eine Schicht des Photoresists auf dem Träger. Die Trocknungstemperatur muss selbstverständlich unterhalb der Temperatur liegen, bei der bestimmte Komponenten des Resists thermisch aushärten könnten. Zur Trocknung sollten die Temperaturen im allgemeinen 80 bis 130 °C nicht übersteigen.

Danach wird die Resistbeschichtung bildmässig durch eine Photomaske, die ein vorbestimmtes Muster enthält, belichtet.

Die Lichtempfindlichkeit der erfindungsgemässen Negativresists reicht je nachdem, welcher strahlungsempfindliche Säuregenerator eingesetzt wird, vom UV-Gebiet (ca. 200 nm) bis ca. 600 nm und umspannt somit einen sehr breiten Bereich, so dass als Lichtquellen an sich eine grosse Anzahl der verschiedensten Typen zur Anwendung kommen können. Es sind sowohl Punktlichtquellen als auch flächenförmige Strahler (Lampenteppiche) geeignet. Beispiele sind: Kohlelichtbogenlampen, Xenon-Lichtbogenlampen, Quecksilberdampflampen, z. B. Quecksilbermittel- und -hochdrucklampen, gegebenenfalls mit Metall-Halogeniden dotiert (Metall-Halogenlampen), Fluoreszenzlampen, Argonglühlampen, Elektronenblitzlampen und photographische

Flutlichtlampen. Der Abstand zwischen Lampe und erfindungsgemässem Bildmaterial kann je nach Anwendungszweck und Lampentyp bzw. -stärke variieren, z.B. zwischen 2 cm bis 150 cm.

Den Photoresists können gegebenenfalls auch Sensibilisatoren zugesetzt werden, um die spektrale Empfindlichkeit in einem bestimmten Wellenlängenbereich zu erhöhen. Zu diesen Sensibilisatoren zählen beispielsweise Michlers Keton, Benzophenone, Phenothiazine, Thioxanthone oder aromatische Kohlenwasserstoffe wie Anthracen, substituierte Anthracene, Pyren oder Perylen.

Vor der Entwicklung ist im allgemeinen ein gewisser Zeitraum erforderlich, damit die Komponenten der Resistzusammensetzung reagieren können. Um diese Reaktion und damit die Ausbildung einer ausreichend stark unterschiedlichen Löslichkeit von bestrahlten und unbestrahlten Partien der Resistbeschichtung im Entwickler zu beschleunigen, wird die Beschichtung vor der Entwicklung bevorzugt erwärmt. Die Erwärmung kann auch schon wahrend der Belichtung durchgeführt werden oder beginnen. Bevorzugt werden Temperaturen zwischen 60 und 150 °C angewandt. Die Zeitdauer richtet sich nach der Erwärmungsweise und kann vom Fachmann notfalls leicht mit einigen Routineversuchen optimiert werden. Sie liegt im allgemeinen zwischen einigen Sekunden und mehreren Minuten. Beispielsweise sind bei Verwendung einer Hotplate 10 bis 300 Sekunden, bei Verwendung eines Konvektionsofens 1 bis 30 Minuten gut geeignet.

Danach wird die Schicht entwickelt, wobei die nicht bestrahlten, besser löslichen Teile der Beschichtung entfernt werden. Gegebenenfalls kann leichtes Bewegen des Werkstücks, leichtes Bürsten der Beschichtung im Entwicklerbad oder Sprühentwicklung diesen Verfahrensschritt beschleunigen. Zu Entwicklung können z. B. die üblichen wässrig-alkalischen Entwickler der Resisttechnologie verwendet werden. Solche Entwickler enthalten z. B. Natrium- oder Kaliumhydroxid, die entsprechenden Carbonate, Bicarbonate, Silikate, Metasilicate, bevorzugt aber metallfreie Basen, wie Ammoniak oder Amine, z. B. Ethylamin, n-Propylamin, Diethylamin, Di-n-propylamin, Triethylamin, Methyldiethylamin, Alkanolamine, z. B. Dimethylethanolamin, Triethanolamin, quarternäre Ammoniumhydroxide, z. B. Tetramethylammoniumhydroxid oder Tetraethylammoniumhydroxid. Die Entwicklerlösungen sind im allgemeinen bis zu 0,5 N, werden aber in der Regel vor Gebrauch in geeigneter Weise verdünnt. Gut einsetzbar sind beispielsweise Lösungen einer Normalität von ca. 0,1 bis 0,3. Die Wahl des jeweiligen Entwicklers richtet sich nach der Art des Photolacks, insbesondere nach der Natur des verwendeten Bindemittels oder der entstehenden Photolyseprodukte. Die wässrigen Entwicklerlösungen können gegebenenfalls auch kleinere Mengen an Netzmitteln und/oder organischen Lösungsmitteln enthalten. Typische organische Lösungsmittel, die den Entwicklerflüssigkeiten zugesetzt werden können, sind beispielsweise Cyclohexanon, 2-Ethoxyethanol, Toluol, Aceton, Isopropanol sowie Mischungen zweier oder mehrerer dieser Lösungsmittel. Ein typisches wässrig/organisches Entwicklungssystem basiert auf Butylcellosolve®/Wasser.

Beispiel 1:

Ein erster Resist (Resist 1) wird aus 22,1 g Polyvinylphenol (PHM-C, Hersteller Maruzen Chemicals), 8,9 g Melaminharz (Cymel®303, Hersteller Cyanamid) und 2,6 g Tribromomethylphenylsulfon (Hersteller Sumitomo) sowie 0,5 g Phenothiazin als Sensibilisator und 66 g Diglyme (Diethylenglycoldimethylether) als Lösungsmittel hergestellt.

Weitere drei Resists (2, 3, 4) werden aus jeweils 18,7 g Polyvinylphenol (PHM-C), 8,9 g Melaminharz Cymel®303, 2,6 g Tribromomethylphenylsulfon, 0,5 g Phenothiazin, 66 g Diglyme sowie im Fall von Resist 2 zusätzlich 3,4 g der Verbindung von Formel II (TRISP-PA, Hersteller Mitsui Petrochemicals), im Fall von Resist 3 zusätzlich 3,4 g 1,2,2,3-Tetrakis-(4-hydroxyphenyl)propan und im Fall von Resist 4 zusätzlich 3,4 g 1,1,2,2-Tetrakis-(4-hydroxyphenyl)ethan hergestellt.

Die Resistlösungen werden nach Feinstfiltration (0,2 µm) so auf jeweils einen Siliciumwafer aufgeschleudert, dass nach 60 Sekunden Trocknung bei 100 °C auf der Hotplate ein Resistfilm von 1,05 µm Dicke resultiert. Die Belichtung der Wafer erfolgt mit Strahlung einer Wellenlänge von 365 Nanometern unter Einsatz eines 5:1 Projektionsbelichters (ASM L PAS 5000/50 Stepper, NA 0,48) in Stufen, wobei von einer Stufe zur anderen entweder die Belichtungsdosis um 10 $mJ/cm^2$ verändert wird oder eine Defokussierung des Systems von 0,3 µm gegenüber der idealen Fokussierung erfolgt und die Belichtungsdosis insgesamt zwischen 20 und 220 $mJ/cm^2$ und die Defokussierung zwischen + 1,5 µm und - 1,5 µm in Bezug auf die ideale Einstellung variiert wird. Der Resistfilm wird danach 60 Sekunden lang bei 110 °C auf der Hotplate ausgeheizt und anschliessend in wässeriger 2,38 %-iger Tetramethylammoniumhydroxid (TMAH) Lösung 90 Sekunden lang entwickelt.

Elektronenmikroskopisch wird die Grenzauflösung bei bester Fokussierung sowie der Fokusspielraum, d. h. der Gesamtbereich in µm ermittelt, um den die Fokussierung gegenüber der Idealeinstellung schwanken kann, ohne dass es dabei zu einer Abweichung der Resiststrukturen um mehr als 0,05 µm (±10 %) gegenüber deren nominellen Abmessungen kommt. Die Werte finden sich in Tabelle 1.

Tabelle 1

| Resist | Fokusspielraum [µm] | Grenzauflösung, l/s* [µm] |
|---|---|---|
| 1 | 1,5 - 1,8 | 0,40 (Nullvergleich) |
| 2 | > 2,1 | 0,35 |
| 3 | > 2,1 | 0,35 |
| 4 | > 2,1 | 0,35 |

*lines and spaces

Man erkennt, dass die erfindungsgemässen Negativresists (Resists 2, 3, 4) einen um mehr als 15 % grösseren Fokusspielraum haben als der Resist 1, der keine Verbindung der Formel I enthält. Zusätzlich wird die Grenzauflösung sowie die Empfindlichkeit gesteigert.

Beispiel 2

Resist 5 wird durch Lösen von 4,7 g m-Kresol-Novolak, 1,2 g Hexa(methoxymethyl)melamin und 0,15 g α-(4-Toluol-sulfonyloxyimino)-4-methoxybenzylcyanid (hergestellt gemäss der in der EP-A-0 241 423 publizierten Vorschrift) in 14 g Diglyme hergestellt. Die Resistlösungen 6, 7 und 8 werden in analoger Weise aus 1,2 g Hexa(methoxymethyl)melamin und 0,15 g α-(4-Toluol-sulfonyloxyimino)-4-methoxybenzylcyanid sowie m-Kresol-Novolak (4,4 g bei Resist 6, 4,2 g bei Resist 7 und 4,0 g bei Resist 8) unter Zusatz unterschiedlicher Mengen der Verbindung der oben angeführten Formel II (0,3 g entsprechend 5 Gewichtsprozent vom Gesamtfeststoff bei Resist 6, 0,6 g entsprechend 10 Gewichtsprozent vom Gesamtfeststoff bei Resist 7 und 0,9 g entsprechend 15 Gewichtsprozent vom Gesamtfeststoff bei Resist 8) und 14 g Diglyme erhalten.

Die Resistlösungen werden wie in Beispiel 1 beschrieben appliziert und belichtet. Nach einer 60 Sekunden langen Erhitzung auf 110 °C auf einer Hotplate wird mit 0,262 N TMAH Lösung entwickelt.

In Tabelle 2 sind die elektronenmikroskopisch ermittelten Ergebnisse für Grenzauflösung und Fokusspielraum zusammengefasst.

Tabelle 2

| Resist | Fokusspielraum [µm] | Grenzauflösung, l/s* [µm] |
|---|---|---|
| 5 | < 1,5 | 0,40 (Nullvergleich) |
| 6 | 1,5 | 0,40 |
| 7 | 1,8 | 0,35 |
| 8 | > 1,8 | 0,35 |

*lines and spaces

Nullvergleich ohne Verwendung einer Verbindung gemäss Formel I).

Beispiel 3:

Resist 9 wird aus 9,7 g m-Kresolnovolak, 2,5 g Hexa(methoxymethyl)melamin, 0,2 g eines strahlungsempfindlichen Säuregenerators der Formel

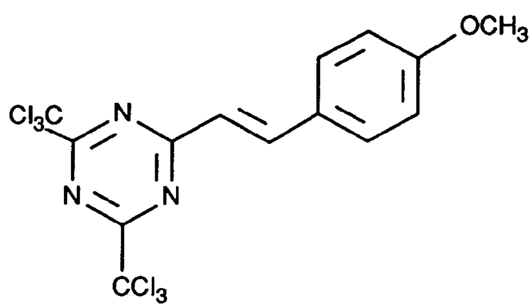

und 27,6 g Diglyme und Resist 10 aus 8,5 g m-Kresolnovolak, 2,5 g Hexa(methoxymethyl)melamin, 0,2 g des Säuregenerators von Resist 9, 27,6 g Diglyme und 1,2 g der Verbindung der oben angeführten Formel II hergestellt.

Die beiden Resistlösungen werden nach Feinstfiltration (0,2 μm) so auf jeweils einen Siliciumwafer aufgeschleudert, dass nach 60 Sekunden Trocknung bei 100 °C auf der Hotplate ein Resistfilm von 1,5 μm Dicke resultiert. Die Belichtung der Wafer erfolgt mit GCA-6400 (NA 0.38) G-Linien Stepper (Wellenlänge 436 Nanometer) in Stufen, wobei von einer Stufe zur anderen entweder die Belichtungsdosis um 5 $mJ/cm^2$ verändert wird oder eine Defokussierung des Systems von 0,3 μm gegenüber der idealen Fokussierung erfolgt und die Belichtungsdosis insgesamt zwischen 20 und 160 $mJ/cm^2$ und die Defokussierung zwischen + 3 μm und - 3 μm in Bezug auf die ideale Einstellung variiert wird. Der Resistfilm wird danach 60 Sekunden lang bei 105 °C auf der Hotplate ausgeheizt und anschliessend in wässeriger 2,38 %-iger Tetramethylammoniumhydroxid (TMAH) Lösung 90 Sekunden lang entwickelt.

Elektronenmikroskopisch wird die Grenzauflösung bei bester Fokussierung sowie der Fokusspielraum, d. h. der Gesamtbereich in μm ermittelt, um den die Fokussierung gegenüber der Idealeinstellung schwanken kann, ohne dass es dabei zu einer Abweichung der Resiststrukturen um mehr als ±10 % gegenüber deren nominellen Abmessungen kommt. Die Werte finden sich in Tabelle 3.

Tabelle 3

| Resist | Fokusspielraum [μm] | Grenzauflösung, l/s* [μm] |
|---|---|---|
| 9 | 2,4 | 0,85 (Nullvergleich) |
| 10 | 3,0 | 0,70 |

*lines and spaces

Ausser dem Fokusspielraum ist hier auch die Grenzauflösung um ca. 20 % besser.

**Patentansprüche**

1. Chemisch verstärkter, wässerig-alkalisch entwickelbarer Negativ-Photoresist, der einen strahlungsempfindlichen Säuregenerator und eine Verbindung, die unter dem Einfluss von Säure die Löslichkeit des Resists in wässerig-alkalischen Lösungen herabsetzt, sowie eine Polyhydroxylverbindung enthält, dadurch gekennzeichnet, dass die Polyhydroxylverbindung die Formel I aufweist

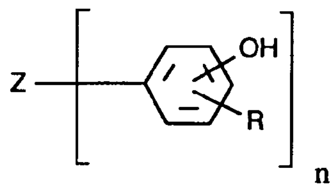

(I),

worin

n eine ganze Zahl zwischen 2 und 6 und

R Wasserstoff, Halogen, $C_1$-$C_4$-Alkoxy oder $C_1$-$C_4$-Alkyl bedeuten sowie

Z einen n-wertigen, unsubstituierten oder einen oder mehrere Substituenten aus der Gruppe Hydroxyl-, Halogen- und $C_1$-$C_4$-Alkoxy-Substituenten aufweisenden Rest darstellt, ausgewählt aus der Gruppe bestehend aus:

a) aliphatischen Resten mit 1 bis 12 Kohlenstoffatomen,
b) cycloaliphatischen Resten mit 5 bis 20 Kohlenstoffatomen,
c) aromatischen Resten mit 6 bis 20 Kohlenstoffatomen und
d) Resten mit 7 bis 30 Kohlenstoffatomen, die aus mindestens zwei verschiedenen Strukturelementen zusammengesetzt sind, ausgewählt aus aliphatischen, cycloaliphatischen oder aromatischen Gruppen.

2. Photoresist gemäss Anspruch 1, dadurch gekennzeichnet, dass n in Formel (I) entweder 3 oder 4 bedeutet.

3. Photoresist gemäss Anspruch 1 oder 2, dadurch gekennzeichnet, dass R in Formel (I) Wasserstoff bedeutet.

4. Photoresist gemäss mindestens einem der Ansprüche 1 bis 3, dadurch gekennzeichnet, dass die Verbindung der Formel (I) folgende Struktur hat

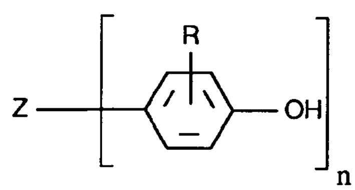

.

5. Photoresist gemäss mindestens einem der Ansprüche 1 bis 4, dadurch gekennzeichnet, dass er die Verbindung der Formel II

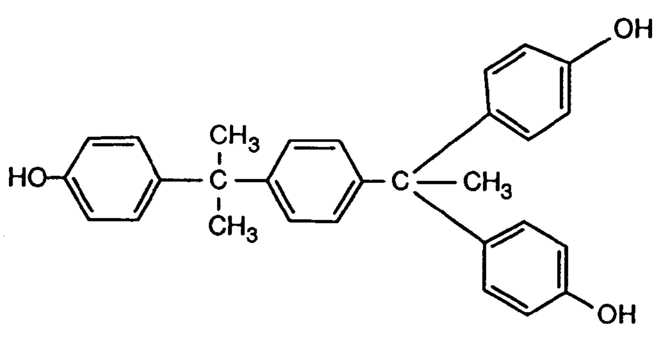

(II)

enthält.

6. Photoresist gemäss mindestens einem der Ansprüche 1 bis 5, dadurch gekennzeichnet, dass er 5 bis 30 Gewichtsprozent der Verbindung der Formel (I) enthält, bezogen auf den Feststoffgehalt des Resists.

7. Photoresist gemäss mindestens einem der Ansprüche 1 bis 6, dadurch gekennzeichnet, dass er der 40 bis 87 Gewichtsprozent eines Phenolharzes als Bindemittel, bevorzugt eines Novolakes oder Polyvinylphenols, 5 bis 25 Gewichtsprozent eines Vernetzungsmittels ausgewählt aus N-Methoxymethylmelamin oder Tetramethoxymethylglycoluril und N,N'-Dimethoxymethyluron in hochreiner oder technischer Form, 0,1 bis 10 Gewichtsprozent einer Verbindung, die bei Bestrahlung Sulfonsäuren oder Halogensäuren bildet, sowie 5 bis 25 Gewichtsprozent einer Polyhydroxylverbindung aus der Gruppe 1,1,2,2-Tetrakis(4-hydroxyphenyl)ethan; 1,2,2,3-Tetrakis(4-hydroxyphenyl)propan, 1,3,3,5-Tetrakis(4-hydroxyphenyl)pentan und der Verbindung der Formel II

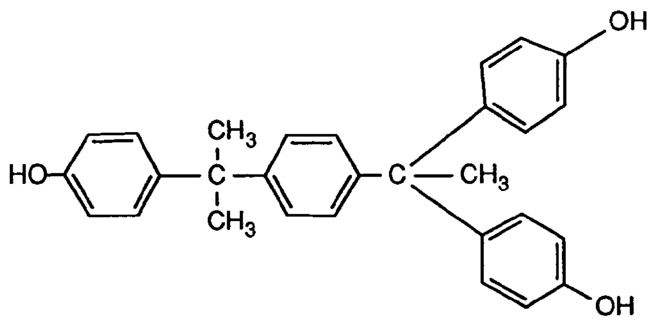

(II)

enthält.

8. Verfahren zur Erzeugung von Abbildungen, das folgende Schritte enthält:
   1. Erzeugung einer Beschichtung bestehend aus dem vorgenannten Photoresist auf einem Substrat;
   2. bildmässige Belichtung des beschichteten Substrats mit Hilfe des Projektionsbelichtungsverfahrens; gegebenenfalls Erwärmung und
   3. Entwicklung mit Hilfe eines wässerig-alkalischen Entwicklers.

Europäisches Patentamt

# EUROPÄISCHER RECHERCHENBERICHT

Nummer der Anmeldung
EP 93 81 0737.2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| X | EP-A-0 295 465 (HOECHST AG)<br>* das ganze Dokument *<br>--- | 1 | G03F7/004 |
| X | CHEMICAL ABSTRACTS, vol. 118, no. 24, 14. Juni 1993, Columbus, Ohio, US; abstract no. 244589v, SAKAGUCHI, S. 'RADIATION-SENSITIVE RESIST COMPOSITION WITH BROAD DEVELOPMENT LATITUDE'<br>Seite 777 ;<br>* Zusammenfassung *<br>& JP-A-04 251 849 (FUJI PHOTO FILM CO., LTD.)<br>--- | 1-4 | |
| X | CHEMICAL ABSTRACTS, vol. 116, no. 2, 13. Januar 1992, Columbus, Ohio, US; abstract no. 13391s, OIE, M. ET AL. 'POSITIVE-WORKING PHOTORESIST COMPOSITION'<br>Seite 464 ;<br>* Zusammenfassung *<br>& JP-A-03 200 254 (NIPPON ZEON CO., LTD.)<br>--- | 1-4 | RECHERCHIERTE SACHGEBIETE (Int.Cl.5)<br>G03F |
| X | CHEMICAL ABSTRACTS, vol. 117, no. 10, 7. September 1992, Columbus, Ohio, US; abstract no. 101054k, OSEKO, H. ET AL. 'POSITIVE PHOTORESIST COMPOSITION CONTAINING POLYHYDRIC PHENOLIC COMPOUND'<br>Seite 762 ;<br>* Zusammenfassung *<br>& JP-A-04 012 357 (TORAY INDUSTRIES, INC.)<br>---<br>-/-- | 1-4 | |

Der vorliegende Recherchenbericht wurde für alle Patentansprüche erstellt

| Recherchenort | Abschlußdatum der Recherche | Prüfer |
|---|---|---|
| DEN HAAG | 22. März 1994 | Rinkel, L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)

Europäisches Patentamt

# EUROPÄISCHER RECHERCHENBERICHT

Nummer der Anmeldung
EP 93 81 0737

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| A | CHEMICAL ABSTRACTS, vol. 118, no. 20, 17. Mai 1993, Columbus, Ohio, US; abstract no. 202087x, OTA, T. ET AL. 'POSITIVE-WORKING PHOTORESIST COMPOSITION' Seite 735 ; * Zusammenfassung * & JP-A-04 274 242 (JAPAN SYNTHETIC RUBBER CO., LTD.) --- | 1 | |
| A | EP-A-0 050 802 (HOECHST AG) * das ganze Dokument * --- | 1 | |
| A | CHEMICAL ABSTRACTS, vol. 115, no. 26, 30. Dezember 1991, Columbus, Ohio, US; abstract no. 291208t, TOKUTAKE, N. ET AL. 'POSITIVE-WORKING PHOTOSENSITIVE RESIN COMPOSITIONS' Seite 767 ; * Zusammenfassung * & JP-A-03 158 854 (TOKYO OHKA KOGYO CO., LTD.) --- | 1 | RECHERCHIERTE SACHGEBIETE (Int.Cl.5) |
| A | EP-A-0 435 437 (NIPPON ZEON CO., LTD.) * das ganze Dokument * --- | 1-8 | |
| A | CHEMICAL ABSTRACTS, vol. 118, no. 18, 3. Mai 1993, Columbus, Ohio, US; abstract no. 180076r, KAWADA, M. ET AL. 'POSITIVE-WORKING PHOTORESIST USING PHENOLIC RESIN AND QUINONEDIAZIDE' Seite 778 ; * Zusammenfassung * & JP-A-04 301 851 (NIPPON ZEON CO., LTD.) --- -/-- | 1-8 | |

Der vorliegende Recherchenbericht wurde für alle Patentansprüche erstellt

| Recherchenort | Abschlußdatum der Recherche | Prüfer |
|---|---|---|
| DEN HAAG | 22. März 1994 | Rinkel, L |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)

Europäisches Patentamt

# EUROPÄISCHER RECHERCHENBERICHT

Nummer der Anmeldung
EP 93 81 0737

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| P,X | EP-A-0 530 148 (CIBA-GEIGY AG;OCG MICROELECTRONICS INC.)<br>* das ganze Dokument *<br>----- | 1-8 | |
| | | | RECHERCHIERTE SACHGEBIETE (Int.Cl.5) |

Der vorliegende Recherchenbericht wurde für alle Patentansprüche erstellt

| Recherchenort | Abschlußdatum der Recherche | Prüfer |
|---|---|---|
| DEN HAAG | 22. März 1994 | Rinkel, L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)